# EUROPEAN PATENT APPLICATION

(11) **EP 3 115 915 A1**
(43) Date of publication of application: **11.01.2017**
(21) Application number: 16175927.9
(22) Date of filing: 23.06.2016
(51) Int. Cl.: G06F 17/50

(54) **GEAR CONTACT MODELING**

(30) Priority: 07.07.2015 US 201514793571
(71) Applicant: Siemens Industry Software NV, 3001 Leuven (BE)
(72) Inventor: Heirman, Gert, 3000 Leuven (BE)
(74) Representative: Maier, Daniel Oliver

(57) **Abstract**

In order to decrease computation requirements for updating ease-off for simulated mating gears upon changed misalignment and calculating corresponding gear penetration, the effect of gear misalignment is linearized. At least one representation of misalignment is added to an initially calculated ease-off to update the ease-off in response to the misalignment. The at least one representation of misalignment includes a representation of relative translation misalignment between the gears, a representation of relative rotational misalignment between the gears, a relative approach between gear flanks at a contact point, or a combination thereof.

## Description

### BACKGROUND

The present embodiments relate to modeling gear contact. Properly designing a gear box and/or individual gears and optimizing their performance ensures the overall product quality in terms of performance (e.g., dynamics, noise, durability, and/or comfort) and efficiency (e.g., maximize energy yield, and/or minimize friction losses). Virtual design optimization of gears may assist in proper design.

For a gear transmission, for example, currently available virtual analysis tools predict forces and loading between gears, which allows durability and noise, vibration, and harshness (NVH) analysis. With the currently available virtual analysis tools (e.g., a virtual toolchain), however, a user makes approximations or assumptions (e.g., an assumption of misalignment) that may only be checked after further time consuming calculations. As another option, a manufactured prototype is tested. Settings of the manufactured prototype may be tuned based on experimental testing. This, however, occurs late in the design process, is more costly than using virtual analysis tools, and has a highly reduced design space (e.g., at this stage in the design process, a number of design and manufacturing choices have already been fixed for the prototype).

### SUMMARY

By way of introduction, the embodiments described below include methods, systems, instructions, and non-transitory computer readable media for modeling gear contact. In order to decrease computation requirements for updating ease-off for simulated mating gears upon changed misalignment and calculating corresponding gear penetration, the effect of gear misalignment is linearized. At least one representation of misalignment is added to an initially calculated ease-off to update the ease-off in response to the misalignment. The at least one representation of misalignment includes a representation of relative translation misalignment between the gears, a representation of relative rotational misalignment between the gears, a relative approach between gear flanks at a contact point, or a combination thereof.

In a first aspect, a method for contact modeling for two gear geometries is provided. The method includes determining, by a processor, for a state of roll motion of a plurality of states of roll motion of a first gear geometry of the two gear geometries, ease-off at a point for an alignment between the first gear geometry and the second gear geometry. The point is a possible idealized point of contact between the two gear geometries at the state of roll motion of the first gear geometry. The processor determines a penetration between the two gear geometries corresponding to the state of roll motion of the first gear geometry and a state of roll motion of the second gear geometry, respectively, based on the determined ease-off and at least one representation of a change in alignment between the two gear geometries

In a second aspect, a non-transitory computer-readable storage medium stores instructions executable by one or more processors to model contact between two gear geometries. The instructions include determining, at each point of a plurality of points representing a portion of a first gear geometry of the two gear geometries, ease-off between the two gear geometries. The instructions also include determining a penetration between the two gear geometries at the point on the portion of the first gear geometry based on the determined ease-off between the two gear geometries and at least one representation of a change in alignment between the two gear geometries.

In a third aspect, a system for modeling gear contact between two gear geometries is provided. The system includes a memory configured to store a pre-calculated ease-off between the two gear geometries. The pre-calculated ease-off corresponds to a possible idealized point of contact at a state of roll motion of the first gear geometry. The system also includes a processor in communication with the memory. The processor is configured to determine a penetration between the two gear geometries corresponding to the state of roll motion based on the pre-calculated ease-off and at least one representation of a change in alignment between the two gear geometries.

In a fourth aspect, a method for contact modeling for two gear geometries is provided. A processor determines, for a state of roll motion of a plurality of states of roll motion of a first gear geometry of the two gear geometries, ease-off at a point. The point is a point of possible contact at the state of roll motion of the first gear geometry. The processor further determines a penetration between the two gear geometries corresponding to the state of roll motion of the first gear geometry and a state of roll motion of the second gear geometry, based on the determined ease-off. The two gear geometries correspond to a geometry of worm gears, a cycloidal gearing geometry, a gear rack geometry, a gear rack geometry with variable transmission ratio, spur cylindrical gearing gear geometry, helical cylindrical gearing gear geometry, geometry of screws of screw compressors, geometry of scrolls of scroll compressors, geometry of impellers of lobe compressors, or any combination thereof.

The present invention is defined by the following claims, and nothing in this section should be taken as a limitation on those claims. Further aspects and advantages of the invention are discussed below in conjunction with the preferred embodiments and may be later claimed independently or in combination.

### BRIEF DESCRIPTION OF THE DRAWINGS

The components and the figures are not necessarily to scale, emphasis instead being placed upon illustrating the principles of the invention. Moreover, in the figures, like reference numerals designate corresponding parts throughout the different views.
Figure 1 is a flow chart diagram of one embodiment of a method for contact modeling;
Figure 2 illustrates an exemplary system for which contact modeling of gears is provided; and
Figure 3 is one embodiment of a system for gear contact modeling.

### DETAILED DESCRIPTION

The present embodiments may provide efficient solving and time integration of contact dynamics. The present embodiments may be used to virtually predict the durability and NVH for a gear transmission, for example, while minimizing the tools in a virtual toolchain and reducing the number of approximations and assumptions.

Ease-off is used for the contact modeling. Ease-off may be a deviation of a gear pair geometry from perfect conjugacy (e.g., the condition in which gears move with respect to each other in perfect kinematic motion transfer while being continuously in contact, without requiring deformation of any of the gears). As gears are meant to smoothly transmit motion, geometries of the gears of the gear pair may be very close to being conjugate, such that typical ease-off values are small (e.g., 10s to 100s of µm, compared to gear sizes of 100s of mm). The small ease-off values allow an assumption that contact happens at a same position of a tooth flank, for example, as would happen for a perfect conjugate gear pair.

Ease-off may be defined as the deviation of the surface of a first gear from the conjugate of a second gear with which the first gear is mating. The conjugacy is defined for a given alignment of the gears with respect to each other. In the following, the reference gear geometry may be the gear geometry of the second gear (i.e., the geometry for which the perfect conjugate gear geometry is computed in the above process to define ease-off).

Ease-off may be defined as the deviation of the surface of a first gear from the conjugate of a second gear with which the first gear is mating. The deviation is measured as angles along circular arcs around the axis of the first gear.

The ease-off/contact modeling is part of modeling using a mesh or other representation of the objects to be modeled (e.g., the gear pair). Any physics or other interaction modeling may be used to model the contact.

The penetration occurring between the perfectly conjugate gear pair may be accurately approximated as the penetration occurring between two corresponding perfectly conjugate gears, plus a contribution due to the fact that the true geometries are not conjugate (i.e., a contribution due to ease-off). Contact analysis between perfectly conjugate gears is less complex compared to exhaustive contact analysis that does not exploit the fact that the gears are close to being conjugate for the given relative alignment. In the present embodiments, the ease-off may be computed in a pre-processing step, allowing for a more efficient contact analysis compared to exhaustive contact analysis of the prior art.

In the prior art, ease-off is recomputed when gears are misaligned, without exploiting values of ease-off computed for the same gear geometries under a different relative alignment. This is computationally cumbersome. One or more of the present embodiments efficiently and accurately update ease-off when misalignment changes by linearizing the effect of gear misalignment.

In the following, ease-off may indicate modifications to be applied to one or two mating gears normal to a flank surface, to provide that the two mating gears become perfectly conjugate (i.e., the gear ratio is constant, kinematics of the gears is perfect; motion is as if the gears perfectly roll over each other). Using this definition, ease-off is a property of a combination of two gears, dependent on relative positioning of the two gears.

In the following, gear geometry may be the geometry of an object (e.g., a first object) that, in combination with a corresponding gear geometry of another object (e.g., a second object), respects an equation of meshing when both objects are in a relative motion, for which the gear geometries of both objects are designed. Alternatively, gear geometry may be the geometry of the object that, in combination with the corresponding gear geometry of the other object, violates the equation of meshing only to a minor extent when both objects are in a relative motion, for which the gear geometries of both objects are designed.

In the following, an "idealized point of contact" may be the middle of a contact patch in the case of a point contact (e.g., may be modeled as a Hertzian contact spreading out the contact force over an elliptical piece of surface), or as a point on a contact line in case of line contact (e.g., may be modeled as a Hertzian line contact with an elliptical load distribution orthogonal to the contact line).

In the following, a "possible idealized point of contact" may be only the points identified as such and may be "idealized points of contact." All other points should not be expected to be 'idealized points of contact', for the given relative positioning of the gear geometries with respect to each other.

In the following, relative alignment between the two objects may be the relative position and the relative orientation, or a combination thereof, of a first axis system, fixed with respect to the first object, and a second axis system, fixed with respect to the second object. In the following, roll motion of a gear geometry may be the component of motion of the gear geometry, with respect to the housing of the gearbox, for which the gear was designed, if the gear geometry moves in an idealized manner with respect to the housing of the gearbox (i.e., no deflection or clearance exists for shafts, bearings, or other components constraining the motion of the gear with respect to the gearbox housing). The roll motion may correspond to a translational motion (e.g., as the idealized motion of a rack in a rack-and-pinion transmission), a rotational motion (e.g., as the idealized motion of a gear of a hypoid gear pair), or a combination thereof.

In the following, the base axis system may be an axis system following the translation of an instantaneous pitch point of the pair of gear geometries. One axis is oriented along a weighted average of the directions of the axes of both gear geometries, and the remaining two axes are oriented such that the components along these remaining two axes of a vector connecting the positions of two reference points (e.g., one reference point per gear that is positioned on the respective axis of the gear geometry) has a fixed ratio independent of the relative orientation of the two gear geometries with respect to each other.

In the following, roll motion of a gear geometry may be the component of motion of the gear geometry with respect to the base axis system, for which the gear was designed. The roll motion may correspond to a translational motion (e.g., as the idealized motion of a rack in a rack-and-pinion transmission), a rotational motion (e.g., as the idealized motion of a gear of a hypoid gear pair), or a combination thereof.

In the following, state of roll motion may be a variable or a combination of variables characterizing a state of roll motion. For example, roll angle may be an angle of rotation characterizing a state of roll motion of a gear geometry.

In the following, for example, in case of a gear rack geometry, roll angle may be a displacement characterizing a state of roll motion of the gear rack geometry.

In the following, in case of a gear rack geometry, roll motion of a gear geometry may be the translational component of motion of the gear geometry, with respect to the base axis system, along the length-wise direction of the gear rack geometry.

In the following, in case of a gear geometry that does not correspond to a gear rack geometry, roll motion of a gear geometry may be the rotational component of motion of the gear geometry, with respect to the base axis system, around the axis of the gear geometry.

Relative alignment between two gear geometries may be characterized as the relative position and the relative orientation of a first axis system, fixed with respect to the first object, and a second axis system, fixed with respect to the second object, excluding components of relative position and orientation that result from motion that has been identified as roll motion.

In the following, misalignment may be a set of displacements and angles indicating the deviation between the given relative alignment between the two gear geometries, and the nominal alignment between the two gear geometries.

In the following, misalignment may be a set of displacements and angles indicating the deviation between the given relative alignment between the two gear geometries, and the alignment between the two gear geometries for which ease-off was computed.

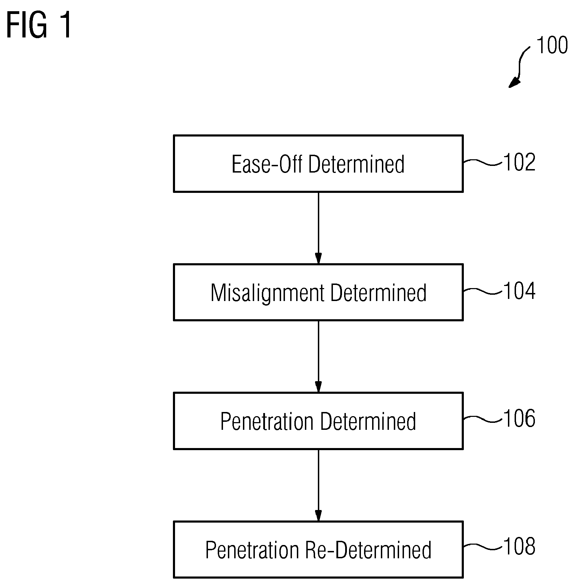

Figure 1 is a flow chart diagram of one embodiment of a method 100 for contact modeling. The method 100 may be for contact modeling two gears. The method is performed in the order shown or other orders. Additional, different, or fewer acts may be provided.

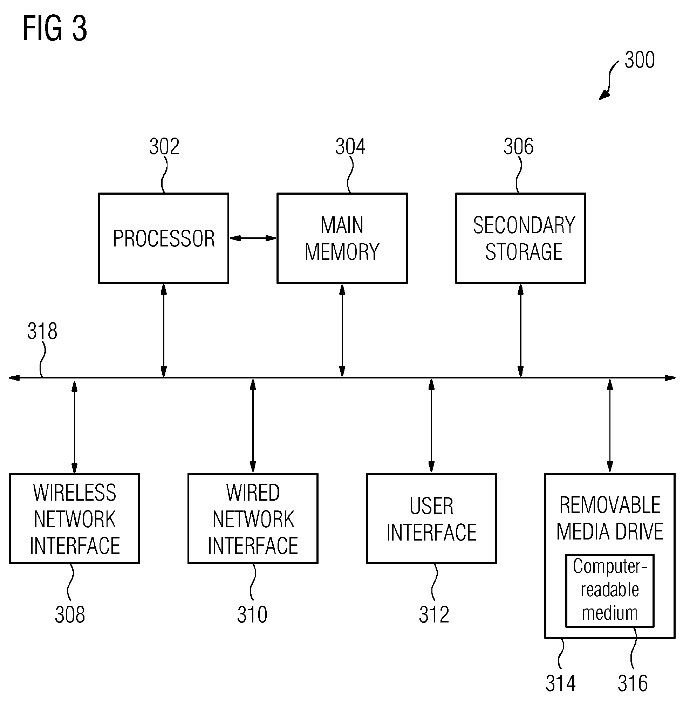

The method simulates the interaction between two gears. The method is implemented by a computer, such as the system of Figure 3 or another system. A user may input information for the simulation, such as a computer assisted design (CAD) of the gears, or the parameters used in the manufacturing process of the gears. Other inputs from memory and/or a user interface may be provided, such as for selecting properties of the gears, time increment, and/or other simulation settings.

The method may be performed for any combination of gear geometries. For example, the gear geometries may be bevel gear geometries, hypoid gear geometries, worm gear geometries, cycloidal gearing gear geometries, gear rack geometries, gear rack geometries with variable transmission ratio, spur cylindrical gearing gear geometries, helical cylindrical gearing gear geometries, geometries of screws of screw compressors, geometries of scrolls of scroll compressors, geometries of impellors of lobe compressors, any other now known or future gears, or any combination thereof. The simulation is for interaction between two gear geometries, such as, for example, two bevel gears (e.g., a gear and a pinion). In other embodiments, the interaction between more than two gear geometries may be simulated.

In act 102, a processor determines, for a roll angle of a plurality of roll angles of a first gear of the two gears, ease-off at a point on the first gear. The ease-off is determined for a given alignment of the first gear and a second gear of the two gears with respect to each other. The point is an ideal point of contact on the first gear at the roll angle of the first gear.

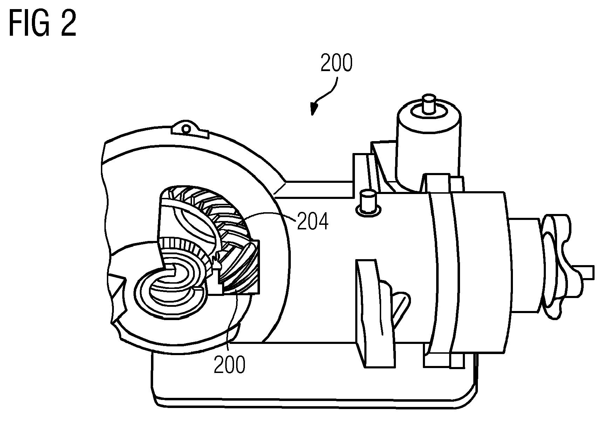

Figure 2 illustrates an exemplary device 200 for which contact modeling of a mating gear and pinion may be provided. The device 200 is a transmission device such as a vehicle differential where a direction of drive from a drive shaft is to be turned 90 degrees to drive wheels of the vehicle. The contact modeling of the present embodiments may, however, be used to model gears of any number of other devices or systems including, for example, a motor or a generator.

The device 200 includes a pinion 202 and a gear 204. The pinion 202 may be the smallest gear in a drive train and may be a drive gear. In the device 200, the pinion 202 drives the gear 204. In one embodiment, the pinion 202 and the gear 204 are spiral bevel gears or hypoid gears. The helical design of the pinion 202 and the gear 204 may produce less vibration and noise than straight-cut gears. Any number of other gear types may be modeled.

Determining the ease-off at the point on the first gear geometry includes selecting one of the two gears to be modeled as the reference gear geometry (e.g., the pinion 202 or the gear 204). The processor may automatically select the one gear based on a default, for example, or the processor may select the one gear based on a user input (e.g., via a keyboard and/or a mouse). The description below assumes the pinion 202 is selected.

Given a relative positioning of the pinion 202 and the gear 204, a gear geometry (e.g., a virtual gear) that would be perfectly conjugate to the pinion 202, when placed at the same relative positioning, is calculated. This provides that the combination of the pinion 202 and the virtual gear (e.g., perfectly conjugate gear) would result in perfect oscillation-free transmission of motion if no deformation would occur.

In act 102, the processor may determine ease-off for a number of different roll angles of the plurality of roll angles and/or for a number of different points on the first gear. For example, the roll angle is a first roll angle, the ease-off is a first ease-off, the point is a first point, the penetration is a first penetration, and the at least one representation of the misalignment is at least one representation of a first misalignment. Any step size for the different roll angles and/or points may be used. The step sizes are regular or vary, such as with a linear or non-linear sampling distribution.

In act 102, according to this embodiment, the processor determines, for a second roll angle of the plurality of roll angles of the first gear, a second ease-off at a second point on the first gear. The second point is a possible idealized point of contact on the first gear at the second roll angle of the first gear. The processor further determines a second penetration between the two gears based on the determined second ease-off and at least one representation of a second misalignment. The second penetration between the two gears corresponds to the second roll angle. The determination of different ease-offs and the determination of different penetrations may be repeated for a number of different roll angles of the plurality of roll angles of the first gear and/or a number of different points on the first gear.

In one embodiment, the following may be performed for each point on a section of the pinion 202, for example. In one embodiment, the section of the pinion 202 is the tooth flank of the pinion 202. The processor computes and stores in a memory the pinion roll angle that causes the corresponding pinion tooth flank point to come in contact with the perfectly conjugate gear (e.g., O surface; 2D to 1D function). The processor computes and stores the roll angle of the perfectly conjugate gear that causes the corresponding pinion tooth flank point to come in contact with the perfectly conjugate gear. The processor computes and stores in the memory coordinates of the corresponding point measured with respect to a gearbox housing where contact is made (e.g., action surface; 2D to 3D function). The processor computes and stores in the memory coordinates of a point on the gear 204, for example, where contact is made, measured with respect to a gearbox housing (e.g., mating points; 2D to 2D or 3D function). The processor computes and stores a local normal to the tooth flank at the point where contact is made, measured in an axis system fixed with respect to the gearbox housing (e.g., normal function; 2D to 3D function), of fixed with respect to the base axis system. The processor then calculates a difference between the perfectly conjugate gear and the gear 204 (e.g., the true gear). In other words, the processor calculates a distance between the tooth flank surfaces of the pinion 202 and the gear 204, measured along circular arcs around the gear shaft. The calculated difference is defined for all of the points on the tooth flank of the pinion 202, for example. The calculated difference is the ease-off.

Whenever trying to detect for contact and computing penetration of tooth flanks (e.g., during static analysis or time-domain simulation), assuming no translational or rotational misalignment, the processor may compute, for example, the points on the pinion 202 for the given roll angle of the pinion 202. Additionally, the processor may compute, for the given roll angle of the pinion 202, at which angle the perfect conjugate gear should be if motion transmission would be kinematically perfect (e.g., instantaneous perfect roll angle), using the gear ratio as conversion, and a difference between the true gear roll angle and the instantaneous perfect roll angle.

The penetration δ, measured orthogonal to the tooth flank at a given possible idealized point of contact, between the gear geometries may be accurately approximated as: δ = ((η*ₙₒₘ* - 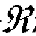 η*instr+n·*θ, in which η*ₙₒₘ* is the roll angle of the conjugate gear geometry in kinematically perfect accordance with the given roll angle of the second gear; η*ᵢₙₛₜ* is the given roll angle of the first gear; r is the radius of the given possible idealized point of contact, measured with respect to the axis of the first gear geometry; 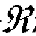 is the value of ease-off computed for the given possible idealized point of contact; *̅n̅*̅ is a unit vector normal to the tooth surface at the given possible idealized point of contact; and θ̂ is a unit vector tangent to a circle around the axis of the second gear geometry, for which the circle goes through the given possible idealized point of contact.

The processor may approximate the "non-normal penetration" between the tooth flank of the pinion 202 and the tooth flank of the gear 204. The "non-normal penetration" may be approximated by ease-off at the corresponding point on the pinion 202 that is in contact at this pinion roll angle, plus the difference between the true gear roll angle and the instantaneous perfect roll angle multiplied by the radius from the gear shaft center at the given point on the gear 204. The penetration normal to the tooth flank surface is then obtained by projecting the approximated "non-normal penetration" onto the local normal to the tooth flank.

The processor may also determine the actual point of the gear 204 that is making contact. The processor may determine the actual point of the gear 204 that is making contact by interpolating for the "mating point" corresponding to the given point on the pinion 202, which was previously computed and stored. The processor projects the non-normal penetration onto a plane normal to a local normal to the tooth flank to obtain a 2D vector. The processor uses the obtained 2D vector to shift the mating point accordingly.

The fact that the true penetration distribution between gears may be accurately approximated based on ease-off relies on the fact that true gear flank geometry and the geometry of the perfectly conjugate gear are typically very close to each other. Gear transmission designers want true gear flank geometry and the geometry of the perfectly conjugate gear to be very close to each other. Otherwise, there would be significant vibration excitation, with severe noise and durability issues.

The advantages of the ease-off based method of approximating true penetration between two gears are that the method provides efficient determination of where contact is made and how much un-deformed geometries interpenetrate. The ease-off method allows the true curved shape of contact lines to be determined, as opposed to classical Tooth Contact Analysis, which looks for the point of most penetration and assumes an ellipse-shaped contact pattern centered around that point, based on the local curvatures of both contacting flanks at that point. The method also provides efficient determination to which point on the gear tooth flank the point of contact corresponds. The method provides efficient computation of load distribution since the curvature of the contacting tooth flanks along the potential contact lines predicted by the ease-off method is known.

At least one representation of misalignment may be used to approximate the true penetration distribution between the pinion 202 and the gear 204 such that ease-off does not have to be recalculated with each change in misalignment. In the prior art, act 102 is repeated with each change in misalignment. In other words, for new relative positioning of gear shafts, ease-off is again computed without exploiting previous results for ease-off, which were computed for the same combination of gear geometries but for different alignments of the gear geometries. In the method of one or more of the present embodiments, ease-off may be updated with changes in misalignment by linearizing the effect of misalignment.

In act 104, the processor determines at least one representation of misalignment between the two gears, respectively, or the at least one representation is given as an input. In one embodiment, the at least one representation of misalignment between the two gears includes a representation of relative translation between the two gears (e.g., the pinion 202 and the gear 204) due to a relative misalignment between the two gears. The at least one representation of the misalignment between the two gears may include a representation of relative translation between geometries of the two gears, respectively, at the point identified as the possible contact point on both gear geometries, respectively, due to a relative translational misalignment between the geometries of the two gears. The at least one representation of the misalignment may also include an additional representation of relative translation between the geometries of the two gears at the point identified as the possible contact point on both gear geometries, respectively. The additional representation of relative translation may be due to a relative rotational misalignment between geometries of the two gears. In one embodiment, the additional representation of relative translation between the pinion 202 and the gear 204, for example, may be calculated. The additional representation of relative translation between the two gears may be calculated by taking the cross product of a vector from an origin of an axis system used to define alignment of the first gear to the point (e.g., a vector product of a vector from a gear shaft of the pinion 202 to the contact point on the gear 204), and a relative rotational misalignment.

In another embodiment, the at least one representation of the misalignment between the two gears includes a relative approach between corresponding flanks of the two gears at the point. The processor may calculate the relative approach between the corresponding flanks of the two gears at the point by projecting deformation due to deformation patterns that are modeled such that a dynamic response is accounted for, onto a local normal to the flanks at the point.

In one embodiment, the at least one representation of the misalignment between the two gears includes, in addition to the relative approach between corresponding flanks of the two gears at the point, a representation of relative translation between the two gears due to a relative rotational misalignment between the two gears and/or a relative translation misalignment between the two gears. The representation of relative translation between the two gears may be calculated by taking the cross product of a vector from an origin of an axis system used to define alignment of the first gear to the point (e.g., a vector product of a vector from a gear shaft of the pinion 202 to the contact point on the gear 204), and the relative rotational misalignment.

In act 106, the processor determines a penetration (e.g., the non-normal penetration) between the two gears, corresponding to the roll angles of the first gear and the second gear, respectively. The determination of the penetration between the two gears is based on the determined ease-off and the at least one representation of a misalignment between the two gears. For example, the processor determines the penetration between the pinion 202 and the gear 204, for example, by adding the at least one representation of the misalignment to the ease-off at the corresponding point on the pinion 202 that is in contact at the corresponding pinion roll angle, plus the product of the difference between the true gear roll angle and the instantaneous perfect roll angle and the radius from the gear shaft center at the given point on the gear 204. The penetration normal to the tooth flank surface is then obtained by projecting the approximated "non-normal penetration" onto the local normal to the tooth flank.

In act 106, one or more possible idealized contact points are identified for the given roll angle of the reference gear geometry. The one or more possible idealized contact points may have been previously calculated and stored in a memory, and a processor may identify the one or more possible idealized contact points. Alternatively, a processor may calculate the one or more possible idealized contact points for the given roll angle of the reference gear geometry within the method 100.

In one embodiment, in act 106, the penetration δ between the gear geometries, measured orthogonal to the tooth flank at a given possible idealized point of contact, may be accurately approximated as: δ = ((ηₙₒₘ - ηᵢₙₛₜ)*r*+ 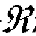 )(*̅n̅*̅·θ̂)+*̅n̅*̅·Δ̅*̅r̅*̅, in which η*ₙₒₘ* is the roll angle of the conjugate gear geometry in kinematically perfect accordance with the given roll angle of the second gear; η*ᵢₙₛₜ* is the given roll angle of the first gear; r is the radius of the given possible idealized point of contact, measured with respect to the axis of the first gear geometry; 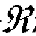 is the value of ease-off computed for the given possible idealized point of contact; *̅n̅*̅ is a unit vector normal to the tooth surface at the given possible idealized point of contact; θ̂ is a unit vector tangent to a circle around the axis of the second gear geometry, for which the circle goes through the given possible idealized point of contact; Δ̅*̅r̅*̅ is the displacement of the point on the conjugate gear surface that, if the conjugate gear would be in perfect kinematic motion transfer with the reference gear geometry, instantaneously coincides with the possible idealized contact point for the given roll angle of the reference gear geometry due to the at least one given representation of the misalignment between the two gears misalignment. In one embodiment, the at least one representation of the misalignment only includes translational misalignments, and Δ̅*̅r̅*̅ is equal to the sum of all of these translational misalignments. In another embodiment, the at least one representation of the misalignment only includes rotational misalignments, and Δ̅*̅r̅*̅ = α̅×*r̅,* where α̅ is the vector representing the combination of all of these rotational misalignments, and r is the vector from the point, of which the displacement defines the translational misalignments, to the possible idealized contact point. In yet another embodiment, the at least one representation of the misalignment includes translational and rotational misalignments, and Δ̅*̅r̅*̅ is equal to the sum of all of these translational misalignments and α̅×*̅r̅*̅, where *a* is the vector representing the combination of all of these rotational misalignments, and r is the vector from the point, of which the displacement defines the translational misalignments, to the possible idealized contact point.

In act 108, the processor re-determines the penetration between the two gears without re-determining the ease-off when the misalignment between the two gears changes. The processor may re-determine the penetration between the two gears by repeating acts 104 and 106 above when the misalignment between the two gears changes. For design purposes, for example, typical values for relative positions of mating gears or for misalignment for a predetermined application may be stored in the memory, and a simulation may execute the method of one or more of the present embodiments to determine penetrations corresponding to the stored values. For the monitoring of actual mating gears, for example, the processor may receive position data from one or more sensors (e.g., positioned on the pinion 202 and/or the gear 204) to determine the change in misalignment, or the processor may receive image data representing the pinion and/or the gear 204 from, for example, a camera and may determine the change in the misalignment based on the generated image data. The processor may determine penetrations based on the real-time change in misalignment. The determined penetrations may be used to predict durability and NVH.

The present embodiments may provide efficient solving and time integration of contact dynamics (e.g., gear contact dynamics). The present embodiments provide an accurate approach to virtually predict the durability and NVH, while minimizing the required tools in the virtual toolchain and reducing the amount of required approximations and assumptions. One or more of the present embodiments take the effect of gear deformation into account for ease-off computation. The ease-off concept may be applied to other gear geometries such as, for example, worm gears.

The application scope of one or more of the present embodiments includes, for example, mechanical simulation of drivetrains (e.g., gears, bearings). One or more of the present embodiments may be used at manufacturers of drivelines in, for example, the transportation sector (e.g., automotive and aeronautics), the machinery sector (e.g., mechanical industries), and the energy sector (e.g., wind turbines, compressors, pumps). When embedded in a software tool, one or more of the present embodiments enable virtual prototyping of product design in a more efficient manner compared to the prior art.

The ease-off concept may be applied to other applications with meshing components similar to gears. For example, the ease-off concept may be applied to applications including compressors, pumps, and engines (e.g., Wankel engines). In one embodiment, in the case of compressors, pumps, and Wankel engines, for example, a "seal line" is to be monitored. If there is contact along a line, leakage of fluid from one chamber to another is prevented along this line. One or more of the present embodiments provide for an efficient computation of the seal line.

Figure 3 shows one embodiment of a system for modeling gear contact. The system is shown as a simplified block diagram of an example apparatus 300. The system is a personal computer, laptop, tablet, workstation, mainframe, server, smart phone, or other computer device. The apparatus 300 includes software and/or hardware to perform any one or more of the activities or operations described herein.

The apparatus 300 includes a processor 302, a main memory 304, secondary storage 306, a wireless network interface 308, a wired network interface 310, a user interface 312, and a removable media drive 314 including a computer-readable medium 316. A bus 318, such as a system bus and a memory bus, may provide electronic communication between the processor 302 and the other components, memory, drives, and interfaces of apparatus 300.

Additional, different, or fewer components may be provided. The components are intended for illustrative purposes and are not meant to imply architectural limitations of network devices. For example, the apparatus 300 may include another processor and/or not include the secondary storage 306 or removable media drive 314. As another example, the apparatus 300 connects with a camera, sensor, and/or microphone.

Instructions embodying the acts or functions described herein may be stored on one or more external computer-readable media 316, in main memory 304, in the secondary storage 306, or in the cache memory of processor 302 of the apparatus 300. These memory elements of apparatus 300 are non-transitory computer-readable media. The logic for implementing the processes, methods and/or techniques discussed herein are provided on non-transitory computer-readable storage media or memories, such as a cache, buffer, RAM, removable media, hard drive or other computer readable storage media. Computer readable storage media include various types of volatile and nonvolatile storage media. Thus, 'computer-readable medium' is meant to include any non-transitory medium that is capable of storing instructions for execution by apparatus 300 that cause the machine to perform any one or more of the activities disclosed herein.

The instructions stored on the memory as logic may be executed by the processor 302. The functions, acts or tasks illustrated in the figures or described herein are executed in response to one or more sets of instructions stored in or on computer readable storage media. The functions, acts or tasks are independent of the particular type of instructions set, storage media, processor or processing strategy and may be performed by software, hardware, integrated circuits, firmware, micro code and the like, operating alone or in combination. Likewise, processing strategies may include multiprocessing, multitasking, parallel processing and the like.

The memory (e.g., external computer-readable media 316, in main memory 304, in the secondary storage 306, or in the cache memory of processor 302) also stores pre-calculated information, numerical models, matrices, and data calculated during processing. As an example, the memory stores the pinion roll angle that causes the corresponding pinion tooth flank point to come in contact with the perfectly conjugate gear, the roll angle of the perfectly conjugate gear that causes the corresponding pinion tooth flank point to come in contact with the perfectly conjugate gear, coordinates of the corresponding point measured with respect to a gearbox housing where contact is made, coordinates of a point on the gear where contact is made, measured with respect to a gearbox housing, or any combination thereof. The memory may alternatively or additionally store material, design, mesh (web), or other characteristics of the gear for simulating.

The wireless and wired network interfaces 308 and 310 may be provided to enable electronic communication between the apparatus 300 and other network devices via one or more networks. In one example, the wireless network interface 308 includes a wireless network interface controller (WNIC) with suitable transmitting and receiving components, such as transceivers, for wirelessly communicating within the network. In another example, the wireless network interface 308 is a cellular communications interface. The wired network interface 310 may enable the apparatus 300 to physically connect to a network by a wire, such as an Ethernet cable. Both wireless and wired network interfaces 308 and 310 may be configured to facilitate communications using suitable communication protocols, such as the Internet Protocol Suite (TCP/IP).

The processor 302, which may also be a central processing unit (CPU), is any general or special-purpose processor capable of executing machine readable instructions and performing operations on data as instructed by the machine readable instructions. The main memory 304 or other memory may be accessible to processor 302 for accessing machine instructions and may be in the form of random access memory (RAM) or any type of dynamic storage (e.g., dynamic random access memory (DRAM)). The secondary storage 306 may be any non-volatile memory, such as a hard disk, which is capable of storing electronic data including executable software files. Externally stored electronic data may be provided to the apparatus 300 through one or more removable media drives 314, which may be configured to receive any type of external media, such as compact discs (CDs), digital video discs (DVDs), flash drives, external hard drives, or any other external media. The processor 302 is configured by the instructions and/or hardware.

In one embodiment, the processor 302 is configured to calculate ease-off, one or more representations of misalignment, non-normal and/or normal penetration, durability, NVH, or any combination thereof. The processor 302 may calculate ease-off, one or more representations of misalignment, non-normal and/or normal penetration, durability, and/or NVH for any number of objects including, for example, bevel gear geometries, hypoid gear geometries, worm gear geometries, cycloidal gearing gear geometries, gear rack geometries, gear rack geometries with variable transmission ratio, spur cylindrical gearing gear geometries, helical cylindrical gearing gear geometries, geometries of screws of screw compressors, geometries of scrolls of scroll compressors, geometries of impellors of lobe compressors, any other now known or future gears, or any combination thereof.

A user interface 312 may be provided in none, some or all devices to allow a user to interact with the apparatus 300. The user interface 312 includes a display device (e.g., plasma display panel (PDP), a liquid crystal display (LCD), or a cathode ray tube (CRT)). In addition, any appropriate input device may also be included, such as a keyboard, a touch screen, a mouse, a trackball, microphone (e.g., input for audio), camera, buttons, and/or touch pad. In other embodiments, only the display (e.g., touch screen) is provided. The display portion of the user interface receives images, graphics, text, quantities, or other information from the processor 302 or memory. The output of the simulation is presented to the user. Based on the output, the user may optimize design of a gear without requiring manufacture of many different designs for testing.

Additional hardware may be coupled to the processor 302 of the apparatus 300. For example, memory management units (MMU), additional symmetric multiprocessing (SMP) elements, physical memory, peripheral component interconnect (PCI) bus and corresponding bridges, or small computer system interface (SCSI)/integrated drive electronics (IDE) elements. The apparatus 300 may include any additional suitable hardware, software, components, modules, interfaces, or objects that facilitate operation. This may be inclusive of appropriate algorithms and communication protocols that allow for the effective protection and communication of data. Furthermore, any suitable operating system is configured in apparatus 300 to appropriately manage the operation of the hardware components therein.

Due to the use of the representations of misalignment, the simulation may be performed more rapidly than in the prior art. For example, in the prior art, ease-off is recomputed if gears are misaligned, without exploiting previous results for ease-off, which were computed for the same combination of gear geometries but for different alignments of the gear geometries. This is computationally cumbersome. One or more of the present embodiments efficiently and accurately update the ease-off by linearizing the effect of gear misalignment. This process allows accurate calculation of noise, durability, and/or efficiency for objects in contact or objects being designed to contact. Using finite element analysis without this approach may take hours or days to simulate gear contact over a same simulated time period on the same laptop.

Product manufacturers of mechanical drivelines benefit from improved processing speed in modeling gear contact. Virtual prototyping of gear box design enables predicting the performance (dynamics, noise, durability) and efficiency with the accuracy desired for industrial designs while keeping the CPU costs affordable. By handling a variety of model representations of gear designs with or without lubrication, surface roughness, damping, successive gear contact, bearing contact, and/or other elements, a large variety of design options is provided in simulation. The products designed using the simulator likely have improved transmission performance (e.g., lower noise, larger durability) and increased efficiency (e.g., lower friction, larger energy yield) due to the refinements possible through virtual testing. Added value is provided for product manufacturers of mechanical drivelines in transportation (e.g., automotive or aeronautics), in machinery (e.g., mechanical industries), and in energy (e.g., wind turbines).

Properties may be input in the user interface of a software tool. The graphic user interface of the tool may have a setting whether to include the multiple gear contacts or only the main gear contact. Other settings for other elements may be provided. In a parametric model order reduction, non-linear finite elements model may be used.
While the invention has been described above by reference to various embodiments, it should be understood that many changes and modifications can be made without departing from the scope of the invention. It is therefore intended that the foregoing detailed description be regarded as illustrative rather than limiting, and that it be understood that it is the following claims, including all equivalents, that are intended to define the spirit and scope of this invention.

## Claims

1. A method for contact modeling for two gear geometries, the method comprising:
determining, by a processor, for a state of roll motion of a plurality of states of roll motion of a first gear geometry of the two gear geometries, ease-off at a point for an alignment between the first gear geometry and the second gear geometry, the point being a possible idealized point of contact between the two gear geometries at the state of roll motion of the first gear geometry; and
determining, by the processor, a penetration between the two gear geometries corresponding to the state of roll motion of the first gear geometry and a state of roll motion of the second gear geometry, respectively, based on the determined ease-off and at least one representation of a change in alignment between the two gear geometries.

2. The method of claim 1, further comprising re-determining, by the processor, the penetration between the two gear geometries without re-determining the ease-off when the alignment between the two gear geometries changes.

3. The method of claim 1, wherein the state of roll motion is a first state of roll motion, the ease-off is a first ease-off, the point is a first point, the penetration is a first penetration, and the at least one representation of the misalignment is at least one representation of a first misalignment, and
wherein the method further comprises:
determining, by the processor, for a second state of roll motion of the plurality of states of roll motion of the first gear geometry, a second ease-off at a second point, the second point being a possible idealized point of contact on the first gear geometry at the second state of roll motion of the first gear geometry; and
determining, by the processor, a second penetration between the two gear geometries based on the determined second ease-off and at least one representation of a second misalignment, the second penetration between the two gear geometries corresponding to the second state of roll motion.

4. The method of claim 1, wherein the at least one representation of the change in alignment between the two gear geometries comprises a representation of relative translation between the two gear geometries at the point due to a change in alignment between the two gear geometries.

5. The method of claim 4, further comprising calculating, by the processor, the representation of relative translation between the two gear geometries, the calculating comprising calculating the cross product of a vector from an origin of an axis system used to define alignment of the first gear geometry or the second gear geometry to the point and the rotational component of the change in alignment.

6. The method of claim 1, wherein the at least one representation of the change in alignment between the two gear geometries comprises a relative approach between corresponding flanks of the two gear geometries at the point.

7. The method of claim 6, further comprising calculating, by the processor, the relative approach between the corresponding flanks of the two gear geometries at the point, the calculating comprising projecting deflection due to deformation patterns, onto a local normal to the flanks at the point.

8. The method of claim 7, wherein the at least one representation of the change in alignment between the two gear geometries further comprises a representation of relative translation between the two gear geometries at the point due to a change in alignment between the two gear geometries, and
wherein the method further comprises calculating, by the processor, the representation of relative translation between the two gear geometries, the calculating of the representation of relative translation between the two gear geometries at the point comprising calculating the cross product of a vector from an origin of an axis system used to define alignment of the first gear geometry or the second gear geometry to the point and the rotational component of the change in alignment.

9. The method of claim 1, wherein the at least one representation of the change in alignment between the two gear geometries comprises a representation of relative translation between the two gear geometries, respectively, at the point identified as the possible idealized contact point on the first gear geometry and the second gear geometry, respectively, due to a translational misalignment between the two gear geometries, and
wherein the at least one representation of the change in alignment further comprises a representation of relative translation between the two gear geometries at the point identified as the possible idealized contact point on the first gear geometry and the second gear geometry, respectively, due to a rotational misalignment between the two gear geometries.

10. In a non-transitory computer-readable storage medium storing instructions executable by one or more processors to model contact between two gear geometries, the instructions comprising:
determining, at each point of a plurality of points representing a portion of a first gear geometry of the two gear geometries, ease-off between the two gear geometries; and
determining a penetration between the two gear geometries at the point on the portion of the first gear geometry based on the determined ease-off between the two gear geometries and at least one representation of a change in alignment between the two gear geometries.

11. The non-transitory computer-readable storage medium of claim 10, wherein the instructions further comprise re-determining the penetration between the two gear geometries, without re-determining ease-off when the alignment between the two gear geometries changes.

12. The non-transitory computer-readable storage medium of claim 10, wherein determining the ease-off between the two gear geometries comprises determining a theoretical state of roll motion that causes the point on the first gear geometry to come into contact with a theoretical second gear geometry, the theoretical second gear geometry representing a gear geometry perfectly conjugate to the first gear geometry.

13. The non-transitory computer-readable storage medium of claim 12, wherein determining the penetration between the two gear geometries comprises determining the penetration between the two gear geometries based on a difference between an actual state of roll motion of a gear geometry and the theoretical state of roll motion of a gear.

14. The non-transitory computer-readable storage medium of claim 10, wherein the at least one representation of the change in alignment between the two gear geometries comprises a representation of relative translation between the two gear geometries due to a relative rotational misalignment between the two gear geometries.

15. The non-transitory computer-readable storage medium of claim 14, wherein the instructions further comprise calculating the representation of relative translation between the two gear geometries, the calculating comprising calculating the cross product of a vector from a gear shaft of a gear to the point, and the relative rotational misalignment.

16. The non-transitory computer-readable storage medium of claim 10, wherein the at least one representation of the misalignment between the two gear geometries comprises a relative approach between corresponding flanks of the two gear geometries at the point.

17. The non-transitory computer-readable storage medium of claim 16, wherein the instructions further comprise calculating the relative approach between the corresponding flanks of the two gear geometries at the point, the calculating comprising projecting deflection due to deformation patterns onto a local normal to the flanks at the point.

18. A system for modeling contact between two gear geometries, the system comprising:
a memory configured to store a pre-calculated ease-off between the two gear geometries, the pre-calculated ease-off corresponding to a possible idealized point of contact at a state of roll motion of the first gear geometry; and
a processor in communication with the memory, the processor being configured to:
determine a penetration between the two gear geometries corresponding to the state of roll motion based on the pre-calculated ease-off and at least one representation of a change in alignment between the two gear geometries.

19. The system of claim 18, wherein the processor is further configured to re-determine the penetration between the two gear geometries without re-determination of the ease-off when the alignment between the two gear geometries changes.

20. The system of claim 18, wherein the first gear geometry is a worm gear or a cycloidal reducer.

21. A method for contact modeling for two gear geometries, the method comprising:
determining, by a processor, for a state of roll motion of a plurality of states of roll motion of a first gear geometry of the two gear geometries, ease-off at a point, the point being a point of possible contact at the state of roll motion of the first gear geometry; and
determining, by the processor, a penetration between the two gear geometries corresponding to the state of roll motion of the first gear geometry and a state of roll motion of the second gear geometry, based on the determined ease-off,
wherein the two gear geometries correspond to a geometry of worm gears, a cycloidal gearing geometry, a gear rack geometry, a gear rack geometry with variable transmission ratio, spur cylindrical gearing gear geometry, helical cylindrical gearing gear geometry, geometry of screws of screw compressors, geometry of scrolls of scroll compressors, geometry of impellers of lobe compressors, or any combination thereof.
